Europäisches Patentamt

European Patent Office

Office européen des brevets

(11) Publication number: **0 258 962**
**A2**

# EUROPEAN PATENT APPLICATION

(21) Application number: **87304490.3**

(22) Date of filing: **20.05.87**

(51) Int. Cl.⁴: **H01L 23/52** , **H01L 21/90**

(30) Priority: **05.09.86 US 904651**

(43) Date of publication of application:
**09.03.88 Bulletin 88/10**

(84) Designated Contracting States:
**DE FR GB NL**

(71) Applicant: **INMOS CORPORATION**
**P.O. Box 16000**
**Colorado Springs Colorado 80935(US)**

(72) Inventor: **Jones, Robert Edwin, Jr.**
**2722 Inspiration Drive**
**Colorado Springs Colorado 80917(US)**
Inventor: **Kammerdiner, Lee**
**39327 Harbour Road**
**Avondale Colorado 81022(US)**

(74) Representative: **Needle, Jacqueline et al**
**PAGE, WHITE & FARRER 5 Plough Place New**
**Fetter Lane**
**London EC4A 1HY(GB)**

(54) **Semiconductor devices having selectively actuable links and a method of manufacturing said devices.**

(57) A semiconductor device (20) having selectively actuable links has a substrate (24) on which a doped region (22) has been formed. An amorphous region (38) of very low conductivity penetrates within the circuit element defined by the doped region (22). The amorphous region (38) is in contact with a metal layer (46) through a window in a dielectric layer (26), and there is thus no electrical connection between the circuit element (22) and the metal layer (46). The amorphous region (38) can be recrystallised and rendered conductive by the application thereto of an energy beam (50), such as green laser light, to thereby constitute a conductive link.

The invention enables high density packing of circuit elements on a semiconductor wafer.

FIG. 5.

## SEMICONDUCTOR DEVICES HAVING SELECTIVELY ACTUABLE LINKS AND A METHOD OF MANUFACTURING SAID DEVICES

The present invention relates to semiconductor devices having selectively actuable links and a method of manufacturing said devices.

It is required to provide selectively actuable links or contacts between circuit elements in integrated semiconductor circuits so that selectively reconfigurable circuits can be built, and it is required that chip surface area required is kept as small as possible.

Previous methods for laser activation, or "writing" of conductive links formed in semiconductor integrated circuits have typically involved "forced material transport" techniques. For example, an insulating layer is positioned between a metal layer and another conducting layer. A laser beam is directed at a selected area of the structure where a contact is to be formed. The concentrated energy of the laser beam generates great heat which creates a hole through the upper metal conductor layer and the insulating layer. It also causes the conductive material of the lower conducting layer to melt and flow or splatter so as to form on the sidewall of the hole a conductive bridge or microweld between the lower conductive layer and the upper metal layer. The upper metal layer may or may not be covered with an additional insulating layer. If an additional insulating layer is present then the heat generated by the laser beam also creates a hole in it. The laser heating may be achieved with a single pulse or with several pulses. One such method is described by J.I. Raffel, M.L. Naiman, R.L. Burke, G.H. Chapman, and P.G. Gottschlak, "Laser Programmed Vias for Restructurable VLSI," Technical Digest, International Electron Devices Meeting, pp. 132-135 (Washington, D.C., Dec. 8-10, 1980) where the insulating layer is sputtered amorphous silicon, and the lower conductive layer is a second metal layer deposited over a silicon dioxide layer over a silicon wafer. A similar technique is described by J.F. Smith, K.T. Yanavage, and R.J. Moulic, "Laser Induced Personalization and Alteration of LSI and VLSI," Proc. First Intern. Laser Processing Conf. (Anaheim, CA, Nov. 16-17, 1981) in which the insulating layer is deposited or thermally grown silicon dioxide and the lower conductor is either a metal layer or a doped region of the silicon substrate. They also report the laser formation of a contact between three conductive layers (two metal layers and the silicon substrate) originally separated by silicon dioxide insulators.

These bulk material movement techniques, however, often result in splatter of material, forced out when the laser opens a hole through a layer, onto adjacent portions of the circuit. This can produce flaws in adjacent electrical circuits. A further disadvantage associated with bulk material transport is the requirement for high energy input into the area where the contact is to be formed. The high energy input produces detrimental thermal effects which could harm nearby circuit elements. These techniques therefore serve to limit the spacing of adjacent circuit elements in the laser write area.

Other techniques have employed lasers to activate lateral conductive linkages (rather than the vertical links described above) by methods which do not require bulk material transport. Diffusion of dopant atoms to areas of lower dopant concentration may be induced by lasers. The thermal energy imparted to the topic material by the laser causes the dopant atoms to move from regions of higher concentration to those of lower concentration. These diffusion techniques have been limited to use with polycrystalline semiconductive materials because the diffusion coefficient of dopant ions in polycrystalline materials is substantially greater than in single crystal materials.

In situations where previously undoped semiconductive links are located between doped semiconductive circuit elements of the same conductive type as the dopant, lasers may be utilized to force dopant atom migration into unannealed, previously undoped, semiconductive areas. M. Hongo, T. Miyauchi, H. Yamaguchi, T. Masuharn, O. Minato, "Connecting Conductors on Semiconducting Devices by Lasers," Conference on Lasers and Electro-Optics, IEEE, p. 62 (New York, 1982).

Another technique of laser activation of conductive links between circuit elements is described in U.S. Patent 4,402,150 to Nishimura et al., issued July 31, 1984 titled "Method of Forming Energy Beam Activated Conductive Regions Between Circuit Elements"; and in an article by D. Parker, F. Lin, and D. Zhang, "Laser Polysilicon Link Making," IEEE Trans. on Components, Hybrids, and Manufacturing Technology, CHMT-7, p. 438-442 (1984). This technique requires the formation of an essentially electrically nonconductive undoped region between two doped regions. Then dopant atoms are implanted in the undoped portion and left unannealed. A laser beam can then be directed at the link region to provide the energy to anneal the region to produce a conductive link. This technique does produce links of low resistance, but to achieve a low resistance, dopant atoms must be provided in doses of $5 \times 10^{15}$ atoms/cm$^2$ or more.

Further, this technique still requires the creation of an initial undoped region which necessitates more complicated doping techniques including an additional masking step.

A major disadvantage of these methods is the requirement that the undoped intrinsic link region which joins the two circuit elements must remain undoped. This prevents the use of thermal diffusion or blanket ion-implantation of dopant atoms in the manufacture of that layer of a semiconductor integrated circuit. Therefore, keeping the intrinsic region undoped increases the cost of production.

It is an object of the invention to provide semiconductor devices having selectively actuable links and a method of manufacturing said devices in which the problems of the prior art are reduced.

According to the present invention there is provided a method of manufacturing semiconductor devices having selectively actuable links between circuit elements comprising the steps of: forming a conductive semiconductor circuit element on a semiconducting substrate;
forming a dielectric layer over at least said semiconductor circuit element;
forming an opening in said dielectric layer to expose a portion of said semiconductor circuit element;
creating a region having very low conductivity in said exposed portion of said semiconductor circuit;
forming a conductive path in contact with said region through said opening; and
selectively activating said region below said conductive path with an energy beam to make said region conductive thereby creating an electrically transmissive link between said semiconductor circuit element and said conductive path.

The invention also extends to a semiconductor device having selectively actuable links comprising:
a conductive semiconductor circuit element formed on a semiconducting substrate said circuit element having a region formed therein which has very low conductivity;
a dielectric layer over at least said circuit element, the dielectric layer having an opening therein above said region;
and
a conductive path in contact with said region through the opening in said dielectric layer, said region arranged to be selectively activated by an energy beam to create an electrically transmissive link between said circuit element and said conductive path.

With a method of the invention relatively low laser intensities are used to activate the link and these do not disrupt any layers, such as passivation layers, above the link. Furthermore, there is no need to maintain an undoped intrinsic region.

In a preferred embodiment, an integrated circuit device, comprised of successive layers of polysilicon and inter-layer dielectric materials on a silicon wafer, has a contact window formed to expose a portion of an underlying doped semiconductive circuit element. This window is formed by conventional photolithographic techniques which etch a pattern through the various layers.

Through the window the exposed portion of the circuit element is bombarded with atoms that are either neutral atoms or ions. When ions are used they may be either of the same conductivity type as the exposed area being bombarded or of the opposite conductivity type as the exposed area being bombarded. However, when ions of the latter type are used, the implant dose of ions must be insufficient to compensate the original doping concentration. This bombardment produces an amorphous or heavily damaged lattice contact region having a very high resistance.

A metal layer is then deposited over the region and patterned to leave a connection to other previously formed semiconductor circuits on the semiconductor wafer. But for the region of low conductivity, there would be an effective coupling between the circuit element and such other previously formed semiconductor circuits to which the metal layer is connected. A dielectric or passivation layer is then formed over the metal layer and the surface of the semiconductor.

After depositing of the aforesaid metal and dielectric layers, an energy beam is utilized selectively to activate selected contacts through the dielectric layer. The energy beam passes through the dielectric layer and contacts the metal layer at an area over the amorphous or heavily damaged lattice region. The metal heats up to a temperature sufficient to cause recrystallization of the amorphous region. In the preferred embodiment the required temperature is 600°C or above with a more preferred temperature of 900°C or above. The recrystallization of the amorphous region can occur either by solid phase recrystallisation or by localised melting. It is important not to exceed the melting temperature of the dielectrics or the boiling temperature of either the silicon or the metal in order to prevent unwanted destruction of the overlaying passivation dielectric.

When the selected contact region has been recrystallized, its resistance drops substantially and becomes conductive again. As a result, the physical path joining the underlying circuit element to the circuit is made electrically conductive. In this manner the circuit elements connected to the metal layer can be selectively electrically connected to the underlying circuit element when desired. This allows the circuit element to be reconfigured after the circuits have been formed.

Embodiments of the present invention will hereinafter be described, by way of example with reference to the accompanying drawings, in which:-

FIG. I shows a cross-sectional segment view of a first embodiment of a semiconductor device having an underlying doped circuit element formed in a semiconductor substrate;

FIG. 2 shows the device of FIG. I after an etching operation;

FIG. 3 shows the device of FIG. 2 undergoing atom bombardment;

FIGS. 4A to 4D show an expanded segment of the device of FIG. 3 undergoing the addition of a metal layer to connect the circuit element shown to a previously formed circuit element;

FIG. 5 shows a segment of the device of FIG. 4 undergoing contact activation;

FIG. 6 shows the device of FIG. 5 after recrystallisation of an amorphous region;

FIGS. 7A to 7C show cross-sectional views illustrating another embodiment of a semiconductor device;

FIG. 8 shows a cross-sectional view illustrating a third embodiment of a semiconductor device;

FIG. 9 shows a cross-sectional view illustrating a fourth embodiment of a semiconductor device; and

FIG. I0 shows a cross-sectional view illustrating a fifth embodiment of a semiconductor device.

Fig. I shows a semiconductor device 20 fabricated on a semiconductor wafer and having an $N^+$ doped circuit element 22 patterned in a P type substrate 24. Whilst the circuit element shown is $N^+$ in a P type substrate for illustration purposes, it is to be understood that this is exemplary, and one skilled in the art could use the same process with other combinations of material. A dielectric layer 26 such as $SiO_2$ is formed on top of element 22 and substrate 24 by a conventional process such as a chemical vapor deposition (CVD) or a thermal growth process to a depth of 6000 to I0,000 angstroms. Then a photoresist film 28 is formed on the dielectric layer 26. An opening 30 is formed in the photoresist 28, by a conventional method, such as photolithography, at an area over the circuit element 22 at which a contact will be formed.

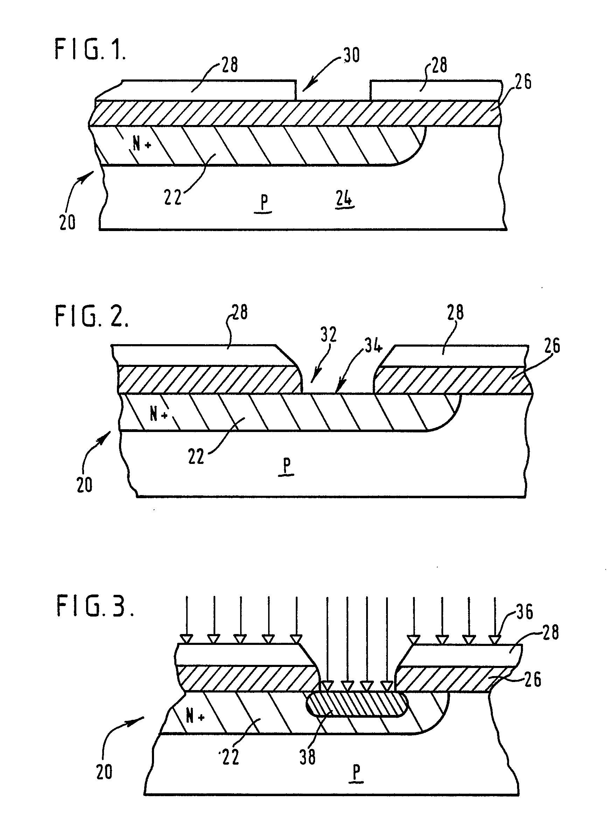

As shown in FIG. 2, a window 32 is then formed in the dielectric layer 26 through opening 30 by a conventional etching process selected to meet the needs of the geometry of the chip. For very high density chips, a plasma etching should be used. The etching process exposes a portion of the underlying $N^+$ doped circuit element 22. This exposed portion is referred to herein as a contact 34.

As shown in FIG. 3, the contact 34 is then exposed to bombardment by dopant atoms 36, or the like, for the purpose of implanting dopant atoms in the exposed portion of the element 22. The dopant atoms produce a region 38 in which the lattice of the bombarded element is heavily damaged. In elements formed of silicon, the region 38 is made amorphous by the bombardment. Elements constructed of material other than silicon may not be rendered amorphous, but their lattices will nevertheless be heavily damaged and rendered nonconductive. The photoresist layer 28 may be removed prior to the atom bombardment. However, in a preferred embodiment the photoresist layer remains in place during the atom bombardment 36 to provide added protection from the bombardment to the unexposed portions of the circuit element 22.

In addition to neutral atoms (such as Si or Ar into Si, or Ar into GaAs), ions of the same conductivity type as the semiconducting circuit element being bombarded (such as B or $BF_2$ into $P^+$ silicon or, as in the illustrated embodiment, P or As into $N^+$ silicon) may be used to create region 38. Or the ions may be of the opposite conductivity type as the semiconducting circuit element being bombarded (such as P into boron doped $N^+$ silicon) but with the dose of ions being insufficient to compensate the original dopant concentration.

The dose of atoms bombarded into the contact 34 ranges from $2 \times 10^{14}/cm^2$ to $5 \times 10^{15}/cm^2$ wherein the atoms have an energy in the range 20 to 300 keV, with a preferred dosage of $1 \times 10^{15}/cm^2$ and an energy of 50 to I00 keV for P, Si, or Ar implants. Lighter implanted ions require a higher dose but a lower energy to achieve the same region of low conductivity, whereas heavier implanted ions require a lower dose but a higher energy to achieve the same region.

The implanted atoms result in the region 38 starting at the exposed contact 34 and extending to a depth of 2000 to 3000 angstroms. As a result of the bombardment, the region 38 has a greatly increased resistivity of about $10\Omega$-cm which results in a resistance in the order of $5 \times 10^3$ to $5 \times 10^4$ ohms for exposed contact diameters of I to 2 microns and is thereby rendered of sufficiently low conduction to act as an open circuit for appropriately designed circuits. As shown in FIGs. 3 to 5, amorphous region 38 need not penetrate the entire circuit element to be effective. However, there must be an overlap 40 of the dielectric layer 26 and the region 38 in which the amorphous region extends laterally past the perimeter of the window 32. This overlap is due to the scattering of the implanted ions and is necessary to enable the high resistance region 38 to electrically isolate circuit element 22 from a metal layer to be described below.

It is preferred that the etch which creates window 32 have a high selectivity to the silicon circuit element 22. If not, and if the resulting contact is etched into the circuit element creating a vertical sidewall extending into the circuit element, then it is possible to recess the contact so deep into the silicon circuit element 22 that the scattered implant atoms can not create the required overlap of amorphous region 38 and dielectric layer 26. However even with a contact etched into the circuit element 22, it is still possible to create the required overlap of region 38 and dielectric layer 26 if the window sidewall is non-vertical or if the etched contact sidewall is non-vertical or both.

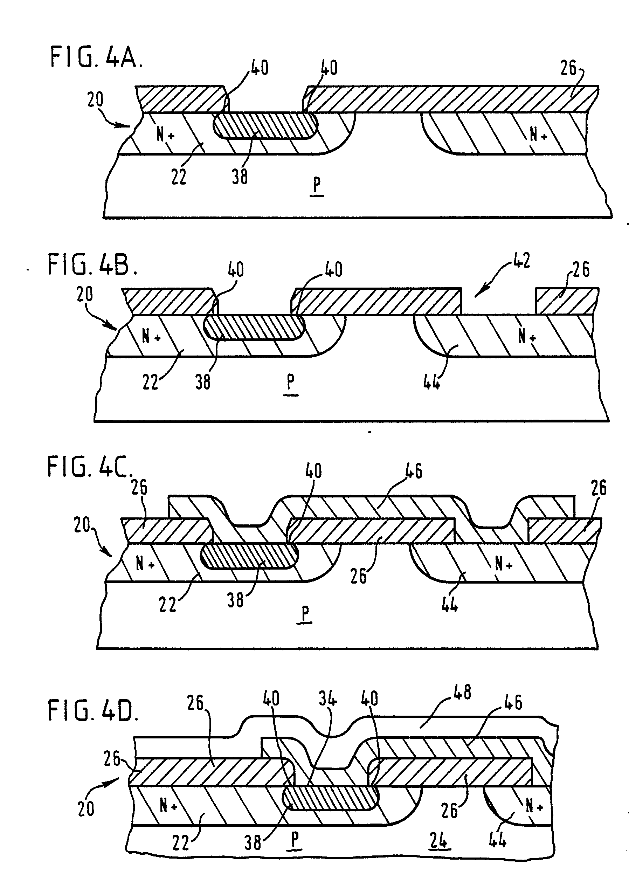

Following the implant step of FIG. 3, processing temperatures are kept below 550°C in order to prevent recrystallisation of region 38. First the photoresist 28 is removed as shown in FIG. 4A (which illustrates a larger segment of the device 20 than is shown in FIGS. 1-3). Then dielectric layer 26 is etched to form a second window 42 over other circuit elements 44 formed in the substrate 24 as shown in FIG. 4B. As depicted in FIG. 4C, a metal layer 46 is then deposited and patterned to form a connection or conductive path between contact 24 and the other circuit elements 44.

In selecting the metal for layer 46, it is important that the composition be chosen to avoid excessive reactions between the doped circuit element 22 and the metal layer 46. In general the refactory transition metals such as tungsten, molybdenum, titanium, and tantalum will have limited interactions with the silicon circuit element 22 and are therefore preferred. The selected metal is deposited by chemical vapor deposition in a layer 5,000 to 10,000 angstroms in depth.

As shown in FIG. 4D, a passivation dielectric layer 48, such as phosphorus silicon glass (PSG) or silicon oxynitride, is then established over the dielectric 26 and the metal layer 46, preferably by CVD or plasma enhanced CVD, but it may also be accomplished by a sputter method. It is not required to have the passivation dielectric layer 48, but in the illustrated embodiment it serves to protect the surface of the semiconductor wafer. At this stage, the illustrated embodiment of the device provides a substrate 24 having a selectively actuable contact 34 (that is part of amorphous region 38) separating metal layer 46 from circuit element 22.

When it is desired to reconfigure the circuit elements, amorphous region 38 can be selectively activated to form an electrically conductive link or contact between the circuit element 22 and the metal layer 46 which is connected to the other circuit elements 44 on the semiconductor wafer.

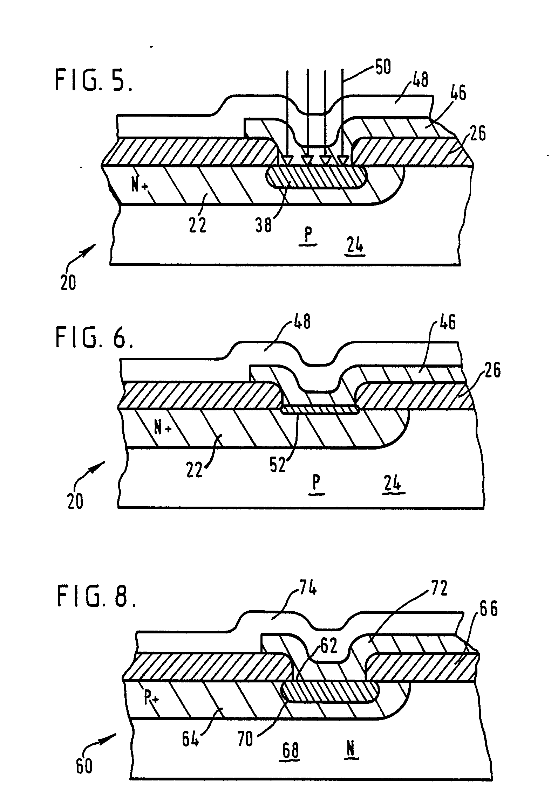

As illustrated in FIG. 5, writing, or activation of a selected region 38 is accomplished by directing an energy beam 50 at that portion of the metal layer 46 over the region 38. While energy beam 50 may be an electron beam, the preferred energy beam is a laser in the blue or green wavelength. A green light laser having an energy of 0.05 to 1.0 J/cm$^2$ and a beam width of 1 to 5 microns is used for writing in a preferred embodiment. This energy level will not affect the passivation layer 48. The laser beam passes through the passivation layer and contacts the metal layer producing a localized temperature of 600°C or above and preferably 900°C or above. The region 38 recrystallizes at temperatures of 600°C and above by either solid phase recrystallization or local melting and resolidification. Temperatures above 900°C are beneficial in terms of obtaining better activation of the dopant atoms present in region 38. These high temperatures also are preferred for the more rapid recrystallization they produce. To prevent destruction of the overlaying passivation layer 48, the passivation layer's melting temperature should not be reached. Nor should either the silicon or the metal reach its vaporization temperature. This recrystallization temperature should also be selected to prevent excessive interface interactions.

In general, the metal layer 46 and the silicon amorphous region 38 will interact at contact 34 interface during the laser heating. Consideration of this reaction is an important factor in the selection of the appropriate metal. The metal-silicon reaction should not extend through the N$^+$ circuit element into the P substrate. Also, the reaction should not result in a doped silicon of the opposite conductivity type as the contacted semiconductor as this would produce an unwanted diode.

In the illustrated embodiment, the metal layer 46 is tungsten which will react with the silicon in a controlled manner to form a thin interface region 52 (FIG. 6) of tungsten silicide following the recrystallization process. The tungsten silicide is a good metallic conductor. The resistivity of the recrystallized previously amorphous region 38 is substantially the same as that of the same region prior to the atom bombardment. However, the overall resistance of the activated structure will be dominated by the metal-semiconductor interface contact resistance. The contact resistance of the tungsten silicide-silicon interface region 52 is appropriately low. This results in an electrically conductive path between the circuit element 22 and the metal layer 46. Other refractory transition metals such as Mo, Ti, and Ta will also form controlled silicide interfaces with low contact resistances. The preferred tungsten metal also has the advantage of not reacting with the silicon dioxide layers at high temperatures.

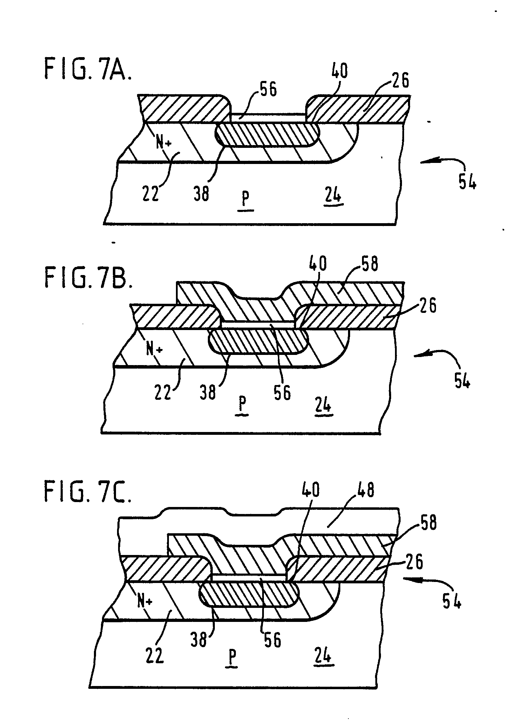

In a second embodiment 54 of a semiconductor device shown in FIG. 7A, the same procedure as described above with reference to FIGS. I-4B could be used to create amorphous region 38 in a circuit element 22. In this embodiment a diffusion barrier 56 is formed prior to formation of a metal layer. The diffusion barrier 56 is established by a selective chemical vapor deposition of tungsten which is put down only on the exposed contact region in a depth of I000 to 2000 angstroms. As shown in FIG. 7B, a metal layer 58 is then formed. This metal layer is followed by the passivation layer 48 as shown in FIG. 7C. The device 54 is then exposed to an energy beam as described above with reference to FIGS. 5 and 6. When exposed to the energy beam, the diffusion barrier 56 will react with the silicon of the circuit element 22 in a controlled manner to form a thin interface region of tungsten silicide as described above. This allows metal layer 58 to be formed with an otherwise incompatible metal such as aluminium, which without the diffusion barrier could react with the silicon to produce an undesirable diode at the interface between the silicon circuit element and the aluminium metal layer.

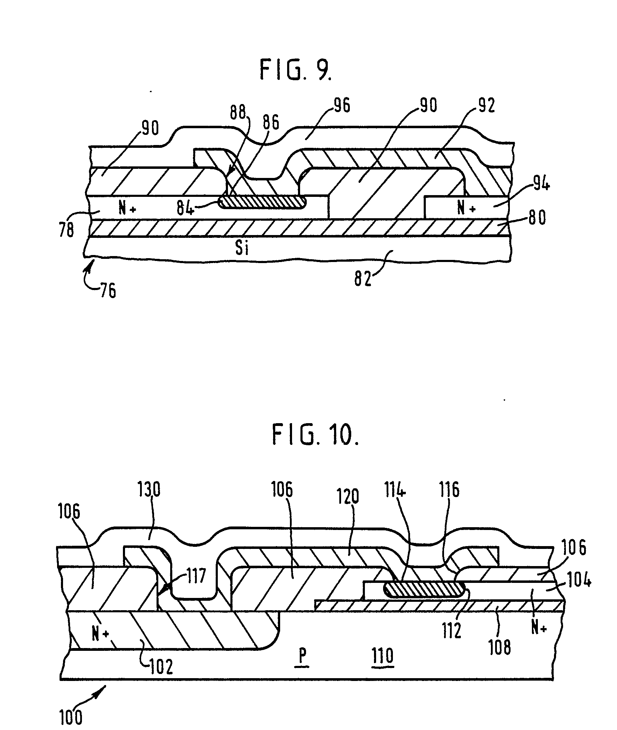

In another embodiment of a semiconductor device 60, shown in FIG. 8, the same procedure as described above with reference to the first device 20 could be used to create a selectively actuable buried contact 62 for a P$^+$ doped circuit element 64, under a dielectric layer 66 in an N type substrate 68. An amorphous region 70 is created by bombardment as described with reference to FIG. 3 above. A metal layer 72 and a passivation layer 74 are then formed successively on the wafer in the manner described with reference to FIGS. 4A-4D. The circuit element 64 may subsequently be connected by an electrically transmissive contact to the metal layer 72 by directing an energy beam at the amorphous region 70 through passivation layer 74 as described with reference to FIG. 5 above.

The same process as described with reference to FIGS. I to 4D may be used to produce the embodiment shown in FIG. 9 in which a device 76 comprises an N$^+$ doped polycrystalline silicon (polysilicon) circuit element 78 formed on a first dielectric layer 80 which covers a silicon substrate 82. As described with reference to FIGS. 2 and 3, ion bombardment is used to form an amorphous region 84 adjacent to an exposed contact 86 of the polysilicon circuit element 78 through a window 88 formed in a second dielectric layer 90. A metal layer 92 is then formed as explained with reference to FIGS. 4A to 4C to cover the contact 86 and to form a connection to other circuit elements 94 formed on the wafer. Metal layer 92 is itself then covered by a passivation dielectric layer 96 as explained with reference to FIG. 4D. An electrically transmissive path may then be selectively formed between the polysilicon circuit element 78 and the metal layer 92 by use of a laser beam as explained with reference to FIGS. 5 and 6.

Another embodiment is shown in FIG. I0, in which a device I00 illustrated is a variation of the device 76 of FIG. 9, and which is produced using the same process as described with reference to FIGS. I to 4D. The device I00 is comprised of an N$^+$ doped circuit element I02 formed in a P type silicon substrate II0 and an N$^+$ doped polycrystalline silicon (polysilicon) circuit element I04 formed on a first dielectric layer I08 which covers at least some portion of substrate II0. As described with reference to FIGS. 2 and 3, ion bombardment through a window II6 forms an amorphous region II2 below a contact II4. A window II7 through a second dielectric layer I06 is cut to form a contact to the circuit element I02. A metal layer I20 is then formed as described with reference to FIGS. 4A to 4C to cover the contact II4 and to form a connection to the circuit element I02 formed in the wafer. A passivation dielectric layer I30 covers the metal layer I20 as explained above with reference to FIG. 4D. An electrically conductive path between the polysilicon element I04 and the metal element I20, and hence to circuit element I02, may then be selectively formed by use of a laser beam to recrystallize the amorphous region II2 as explained with reference to FIGS. 5 and 6.

Illustratively, the circuit element I04 may represent an extension of a polysilicon gate of a decoder transistor, with the metal element I20 representing one of two or more selectable address bus lines each of which are connected to their own amorphous regions II2 in the polysilicon element I04. Each metal element I20 is also connected to an N$^+$ doped circuit element which is the output of a driver transistor of the address circuit. This illustrative example is part of a decoder circuit for a spare row or column in a memory device. This example is illustrative only, and many applications are possible especially for redundancy, customization, and wafer scale integration.

This procedure allows close packing of reconfigurable redundancy circuit elements by eliminating the need for energy inputs which destroy the passivation layer and force molten material into motion. It is also more compact than a lateral link thereby conserving valuable chip space.

**Claims**

I. A method of manufacturing semiconductor devices (20;54;76;I00) having selectively actuable links between circuit elements comprising the steps of:

forming a conductive semiconductor circuit element (22;64;78;104) on a semiconducting substrate (24;68;82;110);

forming a dielectric layer (26;66;80;108) over at least said semiconductor circuit element;

forming an opening (30) in said dielectric layer to expose a portion of said semiconductor circuit element;

creating a region (38;70;84;112) having very low conductivity in said exposed portion of said semiconductor circuit;

forming a conductive path (46;58;72;92;120) in contact with said region through said opening; and

selectively activating said region below said conductive path with an energy beam (50) to make said region conductive thereby creating an electrically transmissive link (52) between said semiconductor circuit element and said conductive path.

2. A method as claimed in Claim l, wherein said region (38;70;84;ll2) is created by introducing into said exposed portion ions of the opposite conductivity type as the dopant previously existing in said exposed portion in an amount sufficient to create said region but insufficient to compensate the initial dopant concentration.

3. A method as claimed in Claim l, wherein said region (38;70;84;ll2) is created by introducing neutral atoms into said exposed portion.

4. A method as claimed in Claim l, wherein said region (38;70;84;ll2) is created by introducing into said exposed portion ions of the same conductive type as the dopant previously existing in said exposed portion.

5. A method as claimed in Claim 4, wherein said doped semiconductor circuit element (22;64;78;l04) is formed of $N^+$ doped polycrystalline silicon and said region (38;70;84;ll2) is created by the introduction of phosphorus ions.

6. A method as claimed in any preceding claim, wherein said region (38;70;84;ll2) is created by introducing ions into said exposed portion in a dose of substantially $1 \times 10^{15}/cm^2$ with an energy of 30 to 300 keV.

7. A method as claimed in any preceding claim, wherein said region (38;70;84;ll2) extends at least partially into said exposed portion of said doped semiconductor circuit element (22;64;78;l04).

8. A method as claimed in any preceding claim, wherein said region (38;70;84;ll2) recrystallizes and becomes conductive after being raised to a temperature greater than 600°C.

9. A method as claimed in any preceding claim, further comprising forming a passivation dielectric layer (48;74;96;l30) over at least said conductive path prior to selectively activating said region.

10. A method as claimed in any preceding claim, wherein said energy beam (50) comprises an electron beam.

11. A method as claimed in any of Claims l to 9, wherein said energy beam comprises a laser beam.

12. A method as claimed in Claim ll, wherein said laser beam is a green light laser having an energy of 0.05 to 1.0 J/cm².

13. A method as claimed in any preceding claim, wherein said conductive path is a metal layer (46;58;72;92;l20).

14. A method as claimed in Claim l3, wherein said metal layer (46;58;72;92;l20) is of tungsten and has a depth in the range 5000 to 10,000 angstroms.

15. A semiconductor device having selectively actuable links comprising:

a conductive semiconductor circuit element (22;64;78;l04) formed on a semiconducting substrate (24;68;82;ll0) said circuit element having a region (38;70;84;ll2) formed therein which has very low conductivity;

a dielectric layer (26;66;80;l08) over at least said circuit element, the dielectric layer having an opening (30) therein above said region; and

a conductive path (46;58;72;92;l20) in contact with said region through the opening in said dielectric layer, said region (38;70;84;ll2) being arranged to be selectively activated by an energy beam (50) to create an electrically transmissive link (52) between said circuit element and said conductive path.

16. A semiconductor device as claimed in Claim l5, wherein said circuit element (22;64;78;l04) is a doped region formed in said semiconducting substrate, and wherein said low conductivity region (38;70;84;ll2) formed therein is substantially amorphous.

17. A semiconductor device as claimed in Claim l6, wherein said amorphous region (38;70;84,ll2) is formed by implanting ions in a dose of substantially $1 \times 10^{15}/cm^2$ with an energy of 30 to 300 keV.

18. A semiconductor device as claimed in claim l6 or l7, wherein said amorphous region (38;70;84,ll2) is arranged to recrystallize and become conductive when raised to a temperature greater than 600°C.

19. A semiconductor device as claimed in any of Claims l5 to l8, further comprising a passivation dielectric layer (48;74;96;l30) over at least said conductive path (46;58;72;92;l20), said passivation dielectric layer being arranged to be substantially transparent to said energy beam (50).

20. A semiconductor device as claimed in any of Claims l5 to l9, wherein said region (38;70;84;ll2) extends within said circuit element such that the dielectric layer (26;66;80;l08) overlaps said region (38,70,84;ll2).

21. A semiconductor device as claimed in any of Claims 15 to 20, wherein said region (38;70,84;112) penetrates only partially into said circuit element.

22. A semiconductor device as claimed in any of Claims 15 to 21, wherein a diffusion barrier layer (56) is formed between said region and said conductive path.

23. A semiconductor device as claimed in Claim 22, wherein said diffusion barrier layer (56) is a metal selected from the group consisting of tungsten, molybdenum, titanium and tantalum.

24. A semiconductor device as claimed in Claim 23, wherein said diffusion barrier layer (56) is tungsten, and said conductive path (46;58;72;92;120) is a layer of aluminium.

25. A semiconductor device as claimed in any of Claims 15 to 23, wherein said conductive path is a metal layer of tungsten and is from 5000 to 10,000 angstroms in depth.

FIG. 1.

FIG. 2.

FIG. 3.

FIG. 4A.

FIG. 4B.

FIG. 4C.

FIG. 4D.

FIG. 5.

FIG. 6.

FIG. 8.

FIG. 7A.

FIG. 7B.

FIG. 7C.

## FIG. 9.

## FIG. 10.